(19) **Europäisches Patentamt**

**European Patent Office**

**Office européen des brevets**

(11) **EP 0 744 095 B1**

(12) **FASCICULE DE BREVET EUROPEEN**

(45) Date de publication et mention
de la délivrance du brevet:
**06.09.2006 Bulletin 2006/36**

(51) Int Cl.:
*H03C 3/09* *(2006.01)*     *H04L 27/20* *(2006.01)*

(21) Numéro de dépôt: **95908304.9**

(22) Date de dépôt: **02.02.1995**

(86) Numéro de dépôt international:
**PCT/FR1995/000129**

(87) Numéro de publication internationale:
**WO 1995/022196 (17.08.1995 Gazette 1995/35)**

(54) **DISPOSITIF DE MODULATION DE PHASE CONTINUE PAR SYNTHETISEUR DE FREQUENCES A BOUCLE A VERROUILLAGE DE PHASE**

EINRICHTUNG ZUR KONTINUIERLICHEN PHASENMODULATION MIT FREQUENZSYNTHETISIERER MIT PHASENREGELSCHEIFE

CONTINUOUS PHASE MODULATION DEVICE USING A FREQUENCY SYNTHESIZER WITH A PHASE-LOCKED LOOP

(84) Etats contractants désignés:
**DE FR GB**

(30) Priorité: **11.02.1994  FR 9401580**

(43) Date de publication de la demande:
**27.11.1996  Bulletin 1996/48**

(73) Titulaire: **Thales**
**92200 Neuilly Sur Seine (FR)**

(72) Inventeurs:
• **FOUSSET, Lionel**
**Thomson-CSF SCPI**
**F-92402 Courbevoie Cédex (FR)**
• **CHELOUCHE, Marc**
**F-92402 Courbevoie Cédex (FR)**
• **DE GOUY, Jean-Luc**
**F-92402 Courbevoie Cédex (FR)**
• **COLLIN, Laurent**
**F-92402 Courbevoie Cédex (FR)**

(74) Mandataire: **Lucas, Laurent Jacques et al**
**Marks & Clerk France**
**31-33 Avenue Aristide Briand**
**94117 Arcueil Cédex (FR)**

(56) Documents cités:
EP-A- 0 325 025     EP-A- 0 408 238
WO-A-91/11852     GB-A- 2 228 840

**EP 0 744 095 B1**

**Description**

La modulation de phase continue par synthétiseur de fréquences à boucle à verrouillage de phase est connue ; les signaux modulants sont des signaux présentant des transitions continues en phase et peuvent être de type analogique ou numérique selon les cas. Parmi les signaux numériques utilisés il y a, entre autres, les signaux dits MSK d'après leur appellation dans la littérature anglo-saxonne qui est le sigle de Minimum Shift Keying, et qui se traduit en français par modulation à déplacement minimum ou, mieux, par modulation à gradient de phase minimal ; une variante des signaux MSK, également utilisable, est constituée par les signaux dits GMSK d'après leur appellation dans la littérature anglo-saxonne : Gaussian Minimum Shift Keying.

Un synthétiseur de fréquences à boucle à verrouillage de phase comporte essentiellement un oscillateur à fréquence commandée et une boucle à verrouillage de phase. L'oscillateur qui sera dit oscillateur variable dans la suite de ce document est appelé voltage controled oscillator ou VCO dans la littérature anglo-saxonne. La boucle d'asservissement comporte successivement, entre la sortie et l'entrée de l'oscillateur variable, un circuit de division de fréquence, un comparateur de phases et un filtre passe-bas ; dans le comparateur le signal de sortie du circuit de division de fréquence est comparé au signal fourni par un oscillateur de référence. Pour effectuer une modulation de phase continue du signal de sortie de l'oscillateur variable il est connu d'appliquer le signal de modulation soit en addition au signal fourni par le filtre à l'oscillateur variable, soit en soustraction au signal fourni par le comparateur de phases au filtre passe-bas, soit en commande du rang de division du circuit de division ; ces trois façons de procéder présentent différents inconvénients qui seront vus plus loin et, parmi ces inconvénients, un inconvénient commun : la bande de modulation est affectée par la bande de la boucle.

Il est connu de réduire ces inconvénients en appliquant le signal de modulation non seulement en addition au signal fourni par le filtre à l'oscillateur mais également, pour compenser les effets de la modulation dans la boucle, en l'appliquant soit en soustraction au signal fourni par le comparateur de phases au filtre passe-bas, soit en commande du rang de division du circuit de division voir par exemple le document EP 0 408 238 A. Malgré tout il reste toujours un résidu de modulation dans le signal de commande élaboré par la boucle et ceci en particulier du fait de la dérive, en température et dans le temps, des composants.

La présente invention a pour but de réduire, voire d'annuler, ce résidu.

Ceci est obtenu, en particulier, en élaborant un signal de correction de manière permanente et donc différemment de ce qui est proposé dans la demande de brevet GB 2 228 840 où le fonctionnement d'un synthétiseur est arrêté pour pouvoir lui appliquer un signal de test spécifique, à la place du signal de modulation, et régler la boucle ; il en résulte non seulement que le fonctionnement du synthétiseur doit être interrompu mais qu'après le réglage, le synthétiseur se dérègle en fonction de la dérive de ses composants.

La présente invention a pour objet un dispositif de modulation de phase continue par synthétiseur de fréquences, avec élimination du résidu de modulation dans la boucle, tel que défini, en particulier, dans la revendication 1.

La présente invention sera mieux comprise et d'autres caractéristiques apparaîtront à l'aide de la description ci-après et des figures s'y rapportant qui représentent :

- les figures 1 à 3, des dispositifs de modulation selon l'art connu
- la figure 4, un schéma général servant d'introduction à la présentation de l'invention,
- les figures 5 à 9, des schémas de montages électroniques, qui complètent le schéma selon la figure 4.

Dans les différentes figures les éléments correspondants sont désignés par les mêmes références.

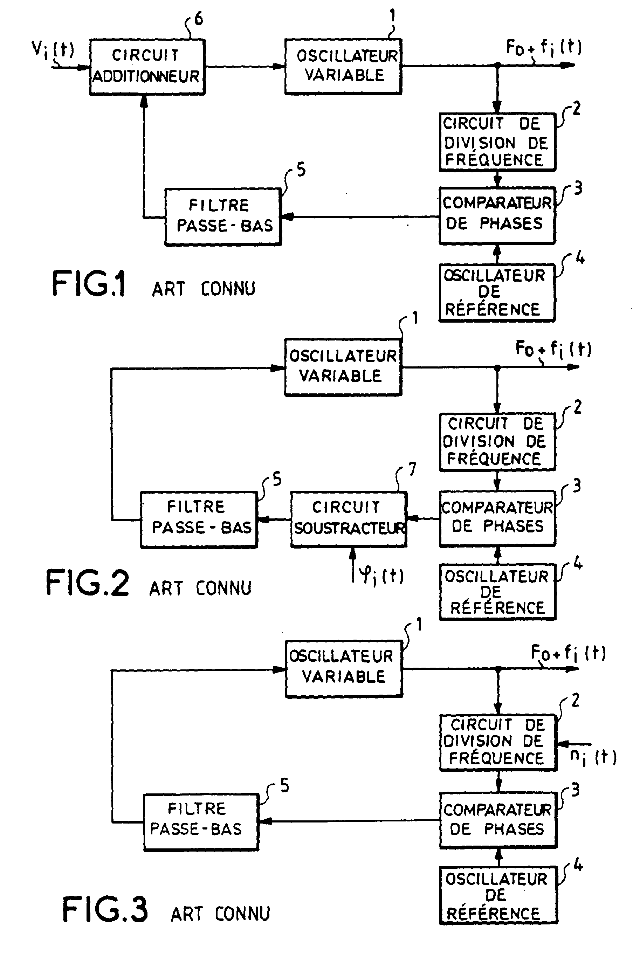

La figure 1 représente un dispositif de modulation selon l'art connu, réalisé à partir d'un synthétiseur de fréquences à boucle à verrouillage de phase c'est-à-dire d'un synthétiseur comportant un oscillateur variable 1 et une boucle d'asservissement en phase de l'oscillateur variable. La boucle comporte un circuit division de fréquence à accumulateur de phase 2, un comparateur de phases 3, un oscillateur de référence 4 qui fournit un signal de fréquence fixe Fr et un filtre passe-bas 5. L'oscillateur variable 1 délivre un signal à la fréquence $\left(N+\dfrac{K}{M}\right)Fr$ où N est un nombre entier et $\dfrac{K}{M}$ une fraction inférieure à 1, avec K et M entiers supérieurs respectivement à -1 et 1 ; ce signal constitue le signal de sortie du synthétiseur et le signal d'entrée du circuit de division de fréquence 2. Le comparateur de phases 3 compare les signaux délivrés par le circuit de division 2 et par l'oscillateur de référence 4 et fournit un signal qui, après filtrage dans le filtre passe-bas 5, constitue un signal de commande en tension de la fréquence de l'oscillateur variable 1.

L'oscillateur variable 1 est commandé en tension par une tension fonction de la fréquence Fo à obtenir et donc

2

de $N + \dfrac{K}{M}$. Le circuit de division de fréquence à accumulateur de phase, 2, comporte un diviseur de fréquence à rang variable prépositionné pour diviser par N et un accumulateur de phase modulo M qui couple la sortie du diviseur à une entrée de commande de ce même diviseur. Le diviseur a une entrée et une sortie de signal qui constituent l'entrée et la sortie de signal du circuit de division de fréquence 2. L'accumulateur de phase comporte une entrée de commande sur laquelle est appliquée la valeur K, de manière que l'accumulateur de phase délivre au diviseur K impulsions pour M périodes du signal de sortie du diviseur. Selon que le diviseur reçoit ou ne reçoit pas une impulsion sur son entrée de commande, son rapport de division passe à la valeur N+1 ou reste à la valeur N. Ainsi, lorsque le synthétiseur, utilisé purement en tant que synthétiseur, donc sans signal de modulation, est synchronisé, c'est-à-dire lorsque le signal de sortie du diviseur est à la fréquence Fr du signal de sortie de l'oscillateur de référence 4, la fréquence du signal d'entrée du diviseur est égale à $\left(N + \dfrac{K}{M}\right)Fr$. L'asservissement réalisé par la boucle de phase produit, à la sortie du filtre 5, une tension de commande de l'oscillateur variable 1 qui amène cet oscillateur à délivrer un signal de fréquence

$$Fo = \left(N + \dfrac{K}{M}\right)Fr.$$ Il est à noter que l'asservissement peut être simplifié et les performances améliorées par un prépositionnement de la commande de l'oscillateur variable aux environs de la fréquence Fo, à l'aide d'une tension continue additionnée à la tension de commande délivrée par la boucle d'asservissement.

Le synthétiseur de fréquences formé des éléments 1 à 5 est utilisé en dispositif de modulation grâce à un circuit additionneur 6 qui permet de commander la fréquence de l'oscillateur 1 par un signal qui est la somme du signal de boucle fourni par le filtre 5 et d'un signal de modulation $V_i(t)$ représentatif d'informations à transmettre. En l'absence du signal $V_i(t)$ le dispositif selon la figure 1 délivre le signal à la fréquence Fo dont il a été question plus avant et, quand le signal $V_i(t)$ est présent, il délivre un signal à la fréquence Fo+$f_i(t)$ où $f_i(t)$ représente la modulation engendrée par $V_i(t)$ autour de la fréquence centrale Fo.

Il est à noter que la figure 1, comme d'ailleurs les autres figures de ce document, est un schéma simplifié sur lequel n'ont été représentés que les éléments nécessaires à la compréhension des explications données dans le présent texte. C'est ainsi que la tension de prépositionnement fonction de $N + \dfrac{K}{M}$ qui est appliquée à l'oscillateur 1 n'a pas été représentée, de même que n'ont pas été représentées les signaux numériques de valeur N et K respectivement appliqués au diviseur de fréquence et à l'accumulateur de phase du circuit de division 2.

Le dispositif de modulation selon la figure 1 présente certains inconvénients :

- la composante $f_i(t)$ de la fréquence modulée Fo+$f_i(t)$ correspond au signal de modulation $V_i(t)$ mais filtré par un filtre passe-haut dont la fréquence de coupure est déterminée par la bande de boucle car, pour la boucle à verrouillage de phase, $V_i(t)$ est perçu comme un signal perturbateur à éliminer,
- la composante $f_i(t)$ est tributaire des variations de la courbe fréquence de sortie/tension de commande de l'oscillateur variable 1.

La figure 2 représente un deuxième dispositif de modulation selon l'art connu, également réalisé à partir d'un synthétiseur de fréquences à boucle à verrouillage de phase. Ce dispositif de modulation se distingue de celui selon la figure 1 par la suppression du circuit additionneur 6, remplacé par une liaison directe entre le filtre passe-bas 5 et l'oscillateur variable 1 ; il s'en distingue également par l'interposition d'un circuit soustracteur 7 entre le comparateur de phases 3 et le filtre passe-bas 5, avec une première entrée reliée à la sortie du comparateur de phases, une seconde entrée et une sortie reliée à l'entrée du filtre passe-bas 5. C'est sur la seconde entrée du circuit soustracteur qu'est appliqué un signal de modulation $\varphi_i(t)$ représentatif des informations à transmettre et qui, dans ce cas, ne se comporte plus comme une tension de commande de l'oscillateur variable 1 mais comme un écart de phase entre le signal modulé Fo+$f_i(t)$ après division et le signal de l'oscillateur de référence 4.

Ce type de circuit de modulation présente deux inconvénients principaux :

- il y a filtrage du signal de modulation par un filtre de largeur équivalente à la bande de boucle,
- $f_i(t)$ est assimilable à la dérivée de $\varphi_i(t)$ or l'indice de modulation, c'est-à-dire l'excursion crête à crête en radians de la modulation de fréquence ou de phase, est limité à N.2$\pi$ où N est le facteur de division du circuit de division de fréquence 2 ; en effet au delà de N.2$\pi$ les limites du comparateur de phase sont franchies.

La figure 3 est relative à un troisième dispositif de modulation selon l'invention, réalisé à partir du même synthétiseur de fréquences que les dispositifs de modulation selon les figures 1 et 2. Dans ce troisième dispositif le signal de modulation est appliqué sur l'entrée de commande du circuit de division de fréquence 2 sous la forme d'un signal de commande de rang de division, $n_i(t)$, représentatif des informations à transmettre ; le signal $n_i(t)$ est formé d'impulsions qui viennent, dans le circuit de division de fréquence, en complément des impulsions fournies par l'additionneur de phase au diviseur de fréquence, comme il a été vu plus avant. Par rapport au schéma selon la figure 1 le circuit d'addition 6 est supprimé et la sortie du filtre 5 est directement reliée à l'entrée de commande de l'oscillateur variable 1.

Le dispositif de modulation selon la figure 3 présente lui aussi l'inconvénient d'avoir une bande de modulation limitée à la bande de boucle.

La fréquence $Fo+f_i(t)$ du signal de sortie du circuit de modulation selon la figure 3 est donnée par $n_i(t)$xFr et $n_i(t)$ effectue donc une commande de modulation quantifiée en niveaux de pas $2\pi$ et quantifiée en temps de pas $1/Fr$. Cette quantification introduit un bruit de quantification dans le signal de sortie du circuit de modulation. Dans ce dispositif de modulation il est à noter que la bande de boucle est nettement inférieure à Fr et cela dans un rapport au moins égal à 10, et que la commande effectuée par $n_i(t)$ constitue, de ce fait, une commande sur-échantillonnée au regard du premier théorème de Shannon ; il est donc possible d'appliquer au signal $n_i(t)$ un algorithme, tel que l'algorithme sigma-delta ou l'algorithme à pas fractionnaires multiples, qui permet de diminuer le bruit de quantification sans toutefois le faire disparaître complètement.

Les modulations décrites à l'aide des figures 1, 2, 3 seront dites respectivement modulations de type 1, 2, 3 dans ce qui suit, afin de simplifier leur dénomination.

La suite de la description se rapporte à des circuits de modulation qui combinent la modulation de type 1 à la modulation de type 2 ou 3, de manière à pouvoir pratiquement éliminer la modulation de phase de la chaîne "circuit de division de fréquence-comparateur de phases", ne laissant plus subsister qu'un résidu de modulation ; il est ainsi possible d'éviter, en particulier, que la bande du signal modulant soit limitée par la bande de boucle. Dans le cas de la combinaison de modulations de types 1 et 2 il reste une limitation en indice de modulation déterminée par une excursion crête de phase limitée à $N.2\pi$ où N est le rapport de division du circuit de division 2. Dans le cas de la combinaison de modulations de types 1 et 3 il n'y a plus de limitation en indice de modulation mais, comme dans la modulation de type 3, il subsiste un bruit de quantification. La combinaison des trois types de modulation évitera, quand elle est parfaitement réalisée, la limitation en indice de modulation et le bruit de quantification, au prix toutefois de réalisations un peu plus compliquées.

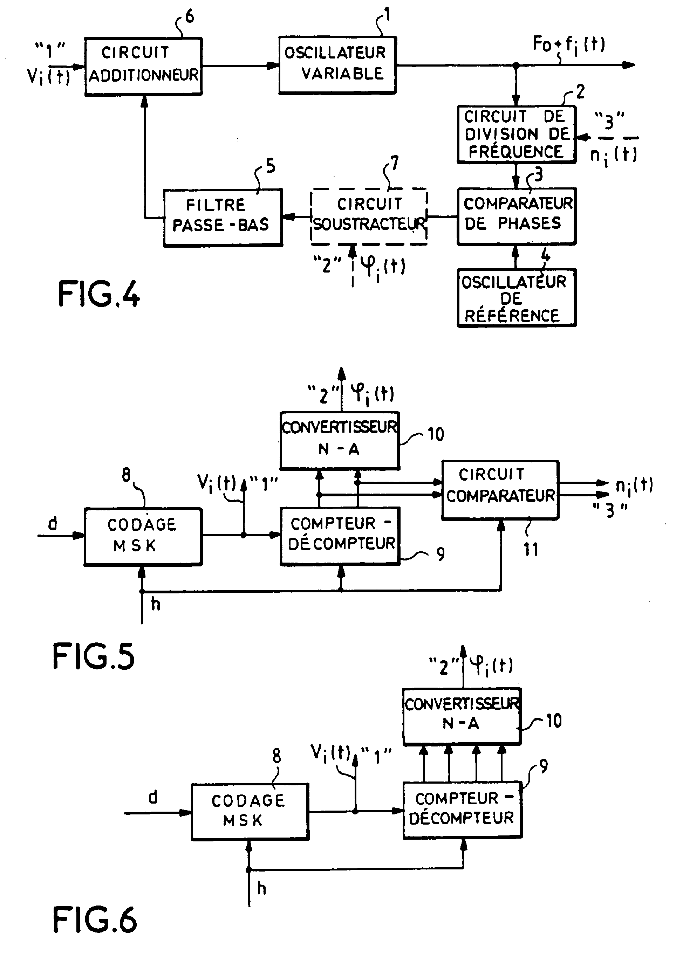

La figure 4 reprend les éléments 1 à 7 des figures 1, 2 et 3 pour montrer comment peuvent être combinés les trois types de modulation :

- modulation de type 1 par signal $V_i(t)$ appliqué sur le circuit additionneur 6,
- modulation de type 2 par signal $\varphi_i(t)$ appliqué sur le circuit soustracteur 7,
- modulation de type 3 par signal $n_i(t)$ appliqué sur le circuit de division de fréquence 2.

Sur la figure 4 les moyens d'introduction des modulations de types 2 et 3, à savoir le circuit soustracteur 7 et la liaison d'amenée du signal $\varphi_i(t)$ sur le circuit soustracteur 7 d'une part et la liaison d'amenée du signal $n_i(t)$ sur le circuit de division de fréquence 2 d'autre part, ont été représentés en traits interrompus pour signifier ainsi que, l'une ou l'autre des modulations de type 2 et 3 peut être présente mais qu'elles peuvent également être présentes simultanément ; dans le cas où la modulation de type 2 est absente, la sortie du comparateur de phases 3 est directement reliée à l'entrée du filtre passe-bas 5 ; dans le cas où la modulation de type 3 est absente la liaison qui aboutit sur l'entrée de commande du circuit de division de fréquence 2 est supprimée et la commande du rang de division du diviseur de fréquence par N ou N+1 se fait de façon habituelle, c'est-à-dire uniquement grâce à l'accumulateur de phase que comporte le circuit de division de fréquence.

La figure 5 montre comment peuvent être obtenus les signaux $V_i(t)$, $\varphi_i(t)$ et $n_i(t)$ nécessaires au fonctionnement du dispositif selon la figure 4 ; cette figure se rapporte à une modulation par signaux MSK ou GMSK. Des donnés, d, à transmettre sont codées, de façon classique, dans un circuit de codage MSK, 8, au rythme d'un signal d'horloge, h, pour fournir le signal $V_i(t)$ utilisé dans la modulation de type 1. Un compteur-décompteur 9 compte au rythme du signal h et son compte augmente d'une unité à chaque fréquence haute du signal MSK et diminue d'une unité à chaque fréquence basse du signal MSK. La modulation MSK étant faite de transitions continues en phase, de valeur $+\dfrac{\pi}{2}$ ou $-\dfrac{\pi}{2}$ selon que la nouvelle fréquence amenée par la transition est une fréquence haute ou une fréquence basse, il peut suffire des deux bits de poids faible du compteur-décompteur 9 pour fournir, à l'aide d'un convertisseur numérique-analogique, 10, un signal $\varphi_i(t)$ de modulation de type 2 qui assure une modulation de phase sur $2\pi$ radians. Ce com-

mutateur à deux bits est suffisant dans le cas où le spectre du signal $\varphi_i(t)$, dans sa partie autour de la fréquence h, est éliminé par le filtre 5. Si ce n'est pas le cas une première solution consiste à transposer ces composantes spectrales gênantes à une fréquence $2^n$ fois plus haute, avec n entier suffisamment élevé ; pour cela il faut faire travailler le compteur 9 à une fréquence $2^n$ fois plus haute et lui répéter $2^n$ fois ses échantillons d'entrée ; le convertisseur 10 devient un convertisseur à n+2 bits. Une seconde solution consiste à insérer un filtre passe-bas analogique en sortie du convertisseur 10 et à retarder la commande $V_i(t)$ destinée au circuit 6, d'une valeur égale au retard dû à ce filtre passe-bas. Les débordements en plus ou en moins, hors de ce domaine de $2\pi$ radians, sont pris en compte par un circuit comparateur 11 qui, au rythme du signal d'horloge h, compare les valeurs successives prises par les deux bits de poids faible du compteur-décompteur 9 ; le circuit comparateur 11 délivre une impulsion sur une première sortie lors du passage du compte du compteur-décompteur 9 de la valeur 11 à la valeur 00, ce passage étant caractéristique d'un débordement positif, et une impulsion sur une deuxième sortie lors du passage de la valeur 00 à la valeur 11 ; ces deux impulsions constituent le signal $n_i(t)$ utilisé dans une modulation de type 3 et font passer le rang de division du circuit de division 2 de la figure 4 respectivement à la valeur N+1 et à la valeur N-1.

Le signal $n_i(t)$ selon la figure 5 peut être utilisé seul, c'est-à-dire sans que soit également utilisé le signal $\varphi_i(t)$, mais le contraire n'est pas vrai à moins que $\varphi_i(t)$ soit limité à une variation de phase de $2\pi$ radians. Dans le cas où le domaine de l'excursion de phase crête à crête est inférieur à $N.2\pi$ radians, il est possible toutefois, en modifiant le montage selon la figure 5, d'effectuer une modulation de type 2 sans modulation de type 3 ; il faut pour cela que le convertisseur numérique-analogique 10 puisse convertir en analogique toute excursion de phase dans le domaine considéré c'est-à-dire que, si ce domaine est compris entre $\pm k\pi$, où k est un entier positif, il faudra que le convertisseur numérique-analogique 10 puisse convertir des valeurs numériques faites d'un nombre de bits égal à 2+log k ou égal à l'entier immédiatement supérieur à $2+\log_2 k$ si $\log_2 k$ n'est pas un entier. La figure 6 illustre cette variante pour k=4 ; cette figure se distingue de la figure 5 par la suppression du circuit comparateur 11 et par un convertisseur 10 à quatre entrées au lieu de 2.

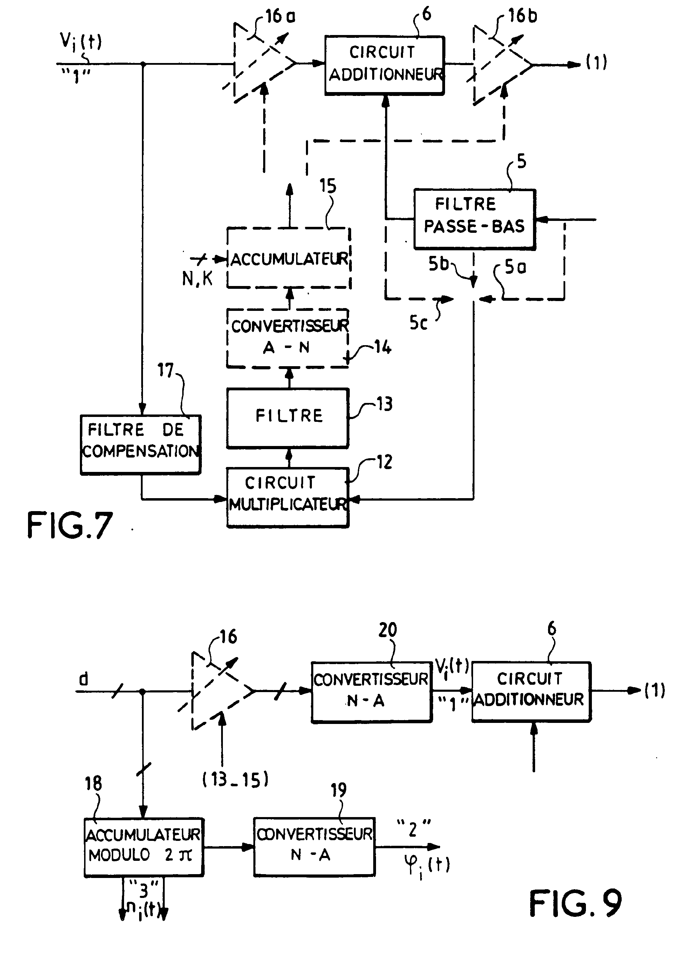

Il est à noter que si la caractéristique de la fréquence de l'oscillateur variable 1 par rapport à sa tension de commande varie en fonction, par exemple de la température ou du Vieillissement, il persiste dans le filtre 5 de la figure 4 un résidu de signal corrélé à la modulation et la modulation n'est pas à la valeur prévue. La figure 7 montre comment corriger ce défaut en utilisant le résidu de modulation pour ajuster la fonction de transfert de la liaison entre l'entrée du dispositif de modulation et la sortie de l'oscillateur variable 1 ; dans l'exemple décrit à l'aide de la figure 7, ceci est obtenu non pas en commandant le gain de l'oscillateur variable 1 mais, ce qui est plus facile à réaliser, en commandant le gain d'un amplificateur variable, 16a ou 16b, placé soit en circuit d'entrée, soit en circuit de sortie du circuit additionneur 6 de la figure 4 ; pour marquer cette possibilité de choix, les amplificateurs 16a, 16b ont été dessinés en traits interrompus, étant entendu qu'un seul des deux est mis en oeuvre l'autre étant remplacé par un court-circuit. De même le résidu de modulation pouvant, au choix, être extrait du signal d'entrée ou de sortie du filtre de boucle, 5, ou même d'un signal pris dans le filtre de boucle, ces trois possibilités ont été symbolisées par trois liaisons en traits interrompus, 5a, 5b, 5c ; et seule une de ces trois possibilités sera mise en oeuvre dans un montage.

Pour obtenir une valeur représentatif du résidu de modulation le signal pris au niveau du filtre de boucle 5 est appliqué sur la première entrée d'un circuit multiplicateur 12 dont la seconde entrée est couplée par un filtre de compensation 17 à l'entrée de modulation de type 1 du dispositif de modulation, c'est-à-dire à l'entrée de modulation qui reçoit le signal $V_i(t)$. Le filtre 17 est réalisé pour produire le même effet de filtrage que la boucle sur une erreur de compensation de modulation. L'association du circuit multiplicateur 12 et du filtre 13 réalise, en fait, la corrélation entre les deux signaux d'entrée du circuit multiplicateur 12, ce qui permet l'extraction d'un signal proportionnel à l'erreur due aux modifications des caractéristiques de l'oscillateur variable 1.

Le signal de sortie du circuit multiplicateur 12, après filtrage dans un filtre passe-bande 13, fournit le signal proportionnel à l'erreur de gain de l'oscillateur variable 1, pour commander le gain de l'amplificateur 16a ou 16b.

Le montage qui vient d'être décrit pour corriger les erreurs de gain de l'oscillateur variable 1 peut être complété, entre la sortie du filtre 13 et l'entrée de commande de l'amplificateur variable, 16a ou 16b, par un convertisseur analogique-numérique 14, suivi d'un accumulateur 15 associé à une mémoire ; en utilisant un convertisseur analogique-numérique 14 qui ne fournit que le bit de signe, l'accumulateur 15 se réduit à un compteur-décompteur. L'accumulateur fournit le signal de commande de l'amplificateur variable 16a ou 16b. Quant à la mémoire de l'accumulateur 15 elle permet, par exemple dans le cas où le dispositif de modulation est amené à fonctionner cycliquement avec différentes fréquences centrales Fo, de garder, d'une utilisation à la suivante de chaque fréquence Fo, la valeur du compteur-décompteur et ainsi de pouvoir commencer une modulation à une fréquence Fo donnée avec un préréglage de la correction du résidu de modulation ; pour cela la mémoire de l'accumulateur 15 comporte autant d'adresses où sont stockées des valeurs du compteur-décompteur qu'il y a de fréquences Fo différentes et l'adressage est réalisé par les valeurs numériques N, K, des fréquences centrales Fo à obtenir. Comme les circuits 14 et 15 ne sont pas toujours mis en oeuvre dans la correction de résidu de modulation, ils ont été dessinés en traits interrompus sur la figure 7 et, en cas de non utilisation, il suffit de modifier la figure 7 en les remplaçant par une liaison directe entre la sortie du filtre 13 et l'entrée de commande de l'amplificateur variable 16a ou 16b.

Il est à remarquer que le signal à la sortie du filtre de compensation 17 de la figure 7 donne la forme de l'erreur c'est-à-dire du résidu de modulation. Pour simplifier le circuit multiplicateur 12 il est donc possible de se contenter de deux niveaux

-1 valeurs négatives
+1 valeurs positives

ou de trois niveaux

-1 valeurs négatives
0 valeur nulle
+1 valeurs positives

pour le signal de sortie du filtre de compensation et cela tout en conservant une information proportionnelle à l'erreur de gain de l'oscillateur variable.

Dans le montage selon la figure 7 le cas où l'extraction du résidu de modulation s'effectue à partir du signal pris à la sortie du filtre passe-bas 5, présente l'avantage d'utiliser un signal bien limité en largeur de bande. Ce signal comporte une composante continue destinée à positionner l'oscillateur variable sur la fréquence Fo ; l'insertion de moyens de prépositionnement de la tension de commande de l'oscillateur 1 entre le filtre 5 et le circuit additionneur 6, permet simultanément de minimiser la composante continue du signal de sortie du filtre 5 et de diminuer le temps de commutation en fréquence de l'oscillateur variable 1.

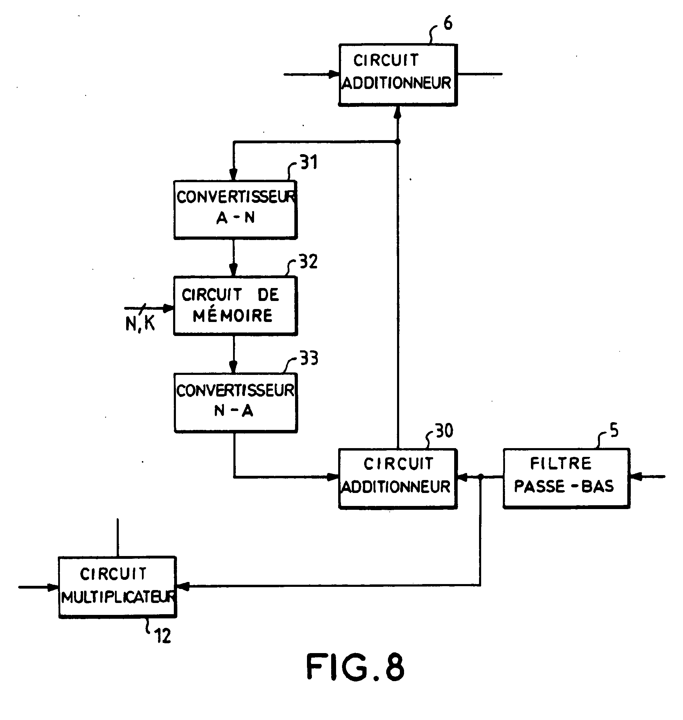

Le schéma d'une réalisation de ces moyens de prépositionnement de la tension de commande de l'oscillateur variable 1 est donné par la figure 8. Dans cette réalisation c'est la sortie du filtre 5 qui est reliée à la première entrée du circuit multiplicateur 12 selon la figure 7 et cette sortie du filtre 5 n'est plus reliée directement au circuit additionneur 6 mais y est couplée à travers des moyens de prépositionnement constitués d'un circuit additionneur 30, d'un convertisseur analogique-numérique 31, d'un circuit de mémoire 32 et d'un convertisseur numérique-analogique 33. La sortie du filtre 5 est reliée à une première entrée du circuit additionneur 30 dont la sortie est reliée au circuit additionneur 6 ; la sortie du circuit 30 est reliée à sa second entrée par le convertisseur 31, suivi du circuit de mémoire 32, lui-même suivi du convertisseur 33. Après stabilisation de la boucle d'asservissement il ne reste plus, à la sortie du circuit additionneur 30, qu'une tension continue dont la valeur, mise en mémoire dans le circuit 32, est disponible pour effectuer un prépositionnement de l'oscillateur variable 1 dès que les paramètres N et K, suite à des sauts de fréquence repassent par les valeurs correspondant à cette mise en mémoire ; les paramètres N, K fournissent l'adresse dans le circuit de mémoire 32 ; l'instant de changement de N, K retardé du temps de stabilisation de la boucle donne l'instant de mise en mémoire à l'adresse N, K ; l'instant de changement de N, K donne l'instant de lecture à l'adresse N, K.

La figure 9 montre comment peuvent être obtenus les signaux $V_i(t)$, $\varphi_i(t)$ et $n_i(t)$ dans le cas d'une modulation de fréquence analogique.

Sur la figure 9 a été représenté en traits interrompus un amplificateur variable, 16, qui remplacerait les amplificateurs 16a, 16b pour la mise en oeuvre éventuelle, dans le montage de la figure 9, du montage de correction de résidu selon la figure 7.

Les données, d, correspondant aux informations à transmettre sont appliquées à l'entrée d'un convertisseur numérique-analogique 20 pour obtenir un signal analogique de modulation de type 1, $V_i(t)$ ; ce signal est appliqué sur le circuit additionneur 6 selon la figure 4. Les données d sont également appliquées à l'entrée d'un accumulateur de phase modulo $2\pi$, 18, dont les passages par 0 et par $2\pi$ fournissent le signal $n_i(t)$ de modulation de type 2, et dont le compte transformé en analogique par un convertisseur numérique-analogique 19 fournit le signal $\varphi_i(t)$ de modulation de type 3.

La présente invention n'est pas limitée aux exemples décrits ci-avant, elle s'applique, en particulier, à toutes les modulations de phase continue par synthétiseur de fréquences à boucle à verrouillage de phase quel que soit le signal de modulation et le synthétiseur.

## Revendications

**1.** Dispositif de modulation de phase continue par synthétiseur de fréquences, comportant un circuit additionneur (6) avec une première entrée recevant le signal de modulation $V_i(t)$, un oscillateur variable (1) avec une entrée de commande couplée à la sortie du circuit additionneur pour recevoir une tension commande et une sortie, une boucle d'asservissement (2-5) avec une entrée couplée à la sortie de l'oscillateur (1) et une sortie couplée a la deuxième entrée du circuit additionneur (6), comportant un oscillateur de référence (4) et successivement entre l'entrée et la sortie de la boucle, un circuit de division de fréquence (2), un comparateur de phases (3) et un filtre de boucle de type passe-bas (5), le comparateur (3) comparant les signaux de sortie du circuit de division (2) et de l'oscillateur de référence (4), et la boucle comportant un parmi deux accès de modulation constitués respectivement par une entrée couplée à l'entrée du filtre de boucle (5) et par une entrée de commande du circuit de division (2), **caractérisé en ce qu'**il comporte des moyens (12-17) de correction permanente des résidus de modulation dans la boucle, ces moyens comportant un filtre de compensation (17) avec une entrée couplée à ladite première entrée ce filtre produisant le même effet de filtrage que la boucle, et un circuit de corrélation (12, 13) avec deux entrées couplées respectivement à la sortie du filtre de compensation et au filtre de boucle et une sortie couplée à l'entrée de commande de l'oscillateur variable, pour fournir un signal de correction.

2.  Dispositif de modulation selon la revendication 1, **caractérisé en ce que** le circuit de corrélation comporte un circuit de multiplication (12) suivi d'un filtre (13).

3.  Dispositif de modulation selon la revendication 1, **caractérisé en ce que** les moyens de correction comportent un amplificateur variable (16a, 16b ; 16) disposé en amont de l'entrée de commande de l'oscillateur variable avec une entrée de commande et **en ce que** le couplage entre la sortie du circuit de corrélation et l'entrée de commande de l'oscillateur variable passe par l'entrée de commande de l'amplificateur variable.

4.  Dispositif de modulation selon la revendication 1, **caractérisé en ce qu'**il comporte des moyens de mémorisation (14, 15) du signal de correction, pour mémoriser le signal de correction lorsque le dispositif travaille avec une fréquence centrale (Fo) de valeur donnée et pour restituer le signal mémorisé lorsque la fréquence centrale, après avoir été modifiée, revient à la valeur donnée.

5.  Dispositif de modulation selon l'une des revendications précédentes, **caractérisé en ce qu'**il comporte des moyens de prépositionnement (30-33) pour prépositionner la tension de commande de l'oscillateur variable (1) lorsque le dispositif travaille avec une fréquence centrale (Fo) de valeur donnée, ces moyens étant disposés entre la sortie du filtre de boucle (5) et l'entrée de commande de l'oscillateur variable (1) et comportant d'une part un circuit additionneur annexe (30) avec une première entrée couplée à la sortie du filtre de boucle et une sortie couplée à l'entrée de l'oscillateur variable et d'autre part, en série entre la sortie du circuit additionneur annexe et une seconde entrée du circuit additionneur annexe, un convertisseur analogique-numérique (31), un circuit de mémoire (32) commandé en fonction (N, K) de la fréquence centrale (Fo) à obtenir par le dispositif et un convertisseur numérique-analogique (33).

**Claims**

1.  Modulation device for continuous phase modulation by frequency synthesizer, comprising an adder circuit (6) with a first input receiving the modulation signal $V_i(t)$, a variable oscillator (1) with a control input coupled to the output of the adder circuit to receive a control voltage, and an output, a slaving loop (2-5) with an input coupled to the output of the oscillator (1) and an output coupled to the second input of the adder circuit (6), comprising a reference oscillator (4) and, successively between the input and the output of the loop, a frequency division circuit (2), a phase comparator (3) and a loop filter of low-pass type (5), the comparator (3) comparing the output signals of the division circuit (2) and of the reference oscillator (4), and the loop comprising one of two modulation accesses which consist respectively of an input coupled to the input of the loop filter (5) and of a control input of the division circuit (2), **characterized in that** it comprises means (12-17) for continuous correction of the modulation residues in the loop, these means comprising a compensation filter (17) with an input coupled to said first input, this filter producing the same filtering effect as the loop, and a correlation circuit (12, 13) with two inputs coupled respectively to the output of the compensation filter and to the loop filter and an output coupled to the control input of the variable oscillator, in order to supply a correction signal.

2.  Modulation device according to Claim 1, **characterized in that** the correlation circuit includes a multiplication circuit (12) followed by a filter (13).

3.  Modulation device according to Claim 1, **characterized in that** the correction means comprises a variable amplifier (16a, 16b; 16) arranged upstream of the control input of the variable oscillator with a control input and **in that** the coupling between the output of the correlation circuit and the control input of the variable oscillator passes through the control input of the variable amplifier.

4. Modulation device according to Claim 1, **characterized in that** it comprises means (14, 15) for memory storage of the correction signal, in order to store the correction signal in memory when the device is working with a central frequency (Fo) of a given value and in order to restore the memory-stored signal when the central frequency, after having been altered, comes back to the given value.

5. Modulation device according to one of the preceding claims, **characterized in that** it comprises presetting means (30-33) for presetting the control voltage of the variable oscillator (1) when the device is working with a central frequency (Fo) of given value, these means being arranged between the output of the loop filter (5) and the control input of the variable oscillator (1) and comprising, on the one hand, an auxiliary adder circuit (30) with a first input coupled to the output of the loop filter and an output coupled to the input of the variable oscillator and, on the other hand, in series between the output of the auxiliary adder circuit and a second input of the auxiliary adder circuit, an analogue-digital converter (31), a memory circuit (32) controlled as a function (N, K) of the central frequency (Fo) to be obtained by the device, and a digital-analogue converter (33).

## Patentansprüche

1. Vorrichtung zur kontinuierlichen Phasenmodulation durch Frequenzsynthetisierer, die eine Addierschaltung (6) mit einem ersten Eingang, der das Modulationssignal $V_i(t)$ empfängt, einen variablen Oszillator (1) mit einem zum Empfang einer Steuerspannung mit dem Ausgang der Addierschaltung verbundenen Steuereingang und mit einem Ausgang, und eine Regelschleife (2-5) aufweist, deren Eingang mit dem Ausgang des Oszillators (1) gekoppelt ist und deren Ausgang mit dem zweiten Eingang der Addierschaltung (6) gekoppelt ist, die einen Bezugsoszillator (4) und nacheinander zwischen dem Eingang und dem Ausgang der Schleife eine Frequenzteilerschaltung (2), einen Phasenkomparator (3) und ein Schleifenfilter vom Tiefpass-Typ (5) aufweist, wobei der Komparator (3) die Ausgangssignale der Teilerschaltung (2) und des Bezugsoszillators (4) vergleicht, und die Schleife einen von zwei Modulationszugängen aufweist, die von einem mit dem Eingang des Schleifenfilters (5) gekoppelten Eingang bzw. von einem Steuereingang der Teilerschaltung (2) gebildet werden, **dadurch gekennzeichnet, dass** sie Mittel (12-17) zur permanenten Korrektur der Modulationsreste in der Schleife aufweist, wobei diese Mittel ein Kompensationsfilter (17), von dem ein Eingang mit dem ersten Eingang gekoppelt ist, wobei dieses Filter die gleiche Filterwirkung erzeugt wie die Schleife, und eine Korrelationsschaltung (12, 13) aufweisen, von der zwei Eingänge mit dem Ausgang des Kompensationsfilters bzw. mit dem Schleifenfilter gekoppelt sind und ein Ausgang mit dem Steuereingang des variablen Oszillators gekoppelt ist, um ein Korrektursignal zu liefern.

2. Modulationsvorrichtung nach Anspruch 1, **dadurch gekennzeichnet, dass** die Korrelationsschaltung eine Multiplizierschaltung (12) gefolgt von einem Filter (13) aufweist.

3. Modulationsvorrichtung nach Anspruch 1, **dadurch gekennzeichnet, dass** die Korrekturmittel einen variablen Verstärker (16a, 16b; 16) aufweisen, der vor dem Steuereingang des variablen Oszillators mit einem Steuereingang angeordnet ist, und dass die Kopplung zwischen dem Ausgang der Korrelationsschaltung und dem Steuereingang des variablen Oszillators über den Steuereingang des variablen Verstärkers verläuft.

4. Modulationsvorrichtung nach Anspruch 1, **dadurch gekennzeichnet, dass** sie Mittel (14, 15) zum Speichern des Korrektursignals aufweist, um das Korrektursignal zu speichern, wenn die Vorrichtung mit einer zentralen Frequenz (Fo) eines gegebenen Werts arbeitet, und um das gespeicherte Signal wiederherzustellen, wenn die zentrale Frequenz, nachdem sie verändert wurde, wieder zum gegebenen Wert zurückkehrt.

5. Modulationsvorrichtung nach einem der vorhergehenden Ansprüche, **dadurch gekennzeichnet, dass** sie Voreinstellungsmittel (30-33) aufweist, um die Steuerspannung des variablen Oszillators (1) voreinzustellen, wenn die Vorrichtung mit einer zentralen Frequenz (Fo) eines gegebenen Werts arbeitet, wobei diese Mittel zwischen dem Ausgang des Schleifenfilters (5) und dem Steuereingang des variablen Oszillators (1) angeordnet sind und einerseits eine Zusatz-Addierschaltung (30), deren erster Eingang mit dem Ausgang des Schleifenfilters gekoppelt ist und deren Ausgang mit dem Eingang des variablen Oszillators gekoppelt ist, und andererseits in Reihe zwischen dem Ausgang der Zusatz-Addierschaltung und einem zweiten Eingang der Zusatz-Addierschaltung einen Analog-Digital-Wandler (31), eine Speicherschaltung (32), die in Abhängigkeit (N, K) von der durch die Vorrichtung zu erreichenden zentralen Frequenz (Fo) gesteuert wird, und einen Digital-Analog-Wandler (33) aufweisen.

**FIG.1** ART CONNU

**FIG.2** ART CONNU

**FIG.3** ART CONNU

"1"
$V_i(t)$

| CIRCUIT ADDITIONNEUR | — 6 |
| OSCILLATEUR VARIABLE | — 1 |

$F_0 + f_i(t)$

CIRCUIT DE DIVISION DE FRÉQUENCE — 2

"3"
$\overline{n_i(t)}$

FILTRE PASSE-BAS — 5

CIRCUIT SOUSTRACTEUR — 7

COMPARATEUR DE PHASES — 3

"2" $\varphi_i(t)$

OSCILLATEUR DE RÉFÉRENCE — 4

## FIG.4

"2" $\varphi_i(t)$

CONVERTISSEUR N-A — 10

$V_i(t)$ "1"

d → CODAGE MSK — 8

COMPTEUR - DÉCOMPTEUR — 9

CIRCUIT COMPARATEUR — 11

$n_i(t)$
"3"

h

## FIG.5

"2" $\varphi_i(t)$

CONVERTISSEUR N-A — 10

$V_i(t)$ "1"

d → CODAGE MSK — 8

COMPTEUR - DÉCOMPTEUR — 9

h

## FIG.6

FIG.7

FIG.9

FIG.8